# EUROPEAN PATENT APPLICATION

(11) **EP 1 607 782 A2**
(43) Date of publication of application: **21.12.2005**
(21) Application number: 05253677.8
(22) Date of filing: 14.06.2005
(51) Int. Cl.: G02B 7/00, G02B 7/02, G02B 13/00, H04N 5/225

(54) **Solid-state imaging device and manufacturing method thereof, and camera module**

(30) Priority: 15.06.2004 JP 2004177419; 19.10.2004 JP 2004304768
(71) Applicant: FUJI PHOTO FILM CO., LTD., Kanagawa (JP)
(72) Inventor: Nishida, Kazuhiro, c/o Fuji Photo Film Co., Ltd., Minami-ashigara-shi, Kanagawa (JP); Maeda, Hiroshi, c/o Fuji Photo Film Co., Ltd., Minami-ashigara-shi, Kanagawa (JP); Yamamoto, Kiyohumi, c/o Fuji Photo Film Co., Ltd., Minami-ashigara-shi, Kanagawa (JP)
(74) Representative: Stevens, Jason Paul

(57) **Abstract**

An optical filter layer (13, 14, 36, 37, 63, 73, 74, 75) composed of an infrared cut filter layer (13, 36, 74), an optical low pass filter layer (14, 37, 75) and the like is formed on a glass substrate (26). The optical filter layer (13, 14, 36, 37, 63, 73, 74, 75) is made either by attaching or depositing. The glass substrate (26) with the optical filter layer (13, 14, 36, 37, 63, 73, 74, 75) is attached to a semiconductor wafer (32), in which imaging sections are arranged in a matrix. The glass substrate (26) and the semiconductor wafer (32) are diced along each imaging section to separate individual solid state imaging device (3, 34, 60, 70).

## Description

### BACKGROUND OF THE INVENTION

### FIELD OF THE INVENTION

The present invention relates to improvements on a solid state imaging device for converting optical images into image signals, a manufacturing method for the solid state imaging device, and a camera module which employs the solid state imaging device.

### BACKGROUND ARTS

Digital cameras and video cameras have become more popular to employ solid state imaging devices. A popular type of the solid state imaging devices includes a solid state imaging chip (or bare chip), a ceramic package for accommodating the solid state imaging chip, and a transparent cover glass for sealing the package. On the solid state imaging chip, plural electrode pads are provided. Connecting these electrode pads to inner connection terminals of the package by wire bonding, then bonding outer connection terminals of the package on a mounting board will establish an electrical connection of the imaging chip to a circuit in the mounting board.

The solid state imaging devices are also employed in portable electronic apparatuses such as cellular phones and electronic agendas (or personal digital assistances), providing them with an image pickup function. To facilitate such provision of the image pickup function, there is a unitized camera module in which the solid state imaging device, an optical unit with an image pickup optical system, and a mounting board with a control circuit are put together.

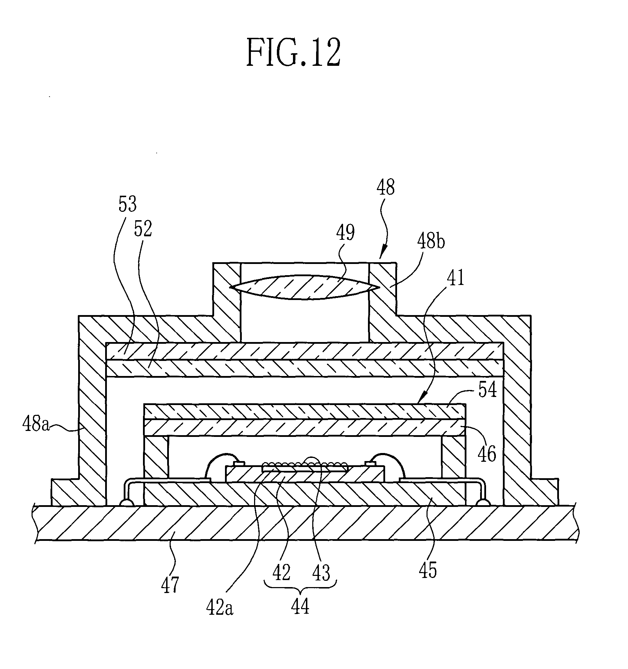

Fig.12 shows a conventional camera module which employs a ceramic package type solid state imaging device 41. This camera module is composed of the solid state imaging device 41, an optical unit 48, and a mounting board 47. The solid state imaging device 41 is constituted of a solid state imaging chip 44, a package 45 for accommodating the solid state imaging chip 44, and a cover glass 46 for sealing the package 45, and is attached on the mounting board 47. The solid state imaging chip 44 is configured with a semiconductor substrate 42 with an imaging section 42a, which has plural pixels arranged in a matrix, and a microlens array 43 attached on the imaging section 42a. The optical unit 48 includes a housing portion 48a for accommodating the solid state image device 41 and a lens barrel 48b to hold a taking lens 49, and is fixed to the mounting board 47.

The above camera module uses an infrared cut filter 52 and an optical low pass filter 53 to improve image quality. In addition, an anti-reflection filter 54 may be attached on the upper surface of the cover glass 46 to prevent the incident light reflecting diffusely inside the solid state imaging device 41. Since these infrared cut filter 52 and optical low pass filter 53 are placed between the solid state imaging device 41 and the taking lens 49 in the optical unit 48, their attachment spaces cause the camera module to grow in size. One solution to this problem is indicated in the Japanese patent laid-open publication No.2004-064272, which discloses a solid state imaging device with a sheet of infrared cut filter on the cover glass.

The solid state imaging devices are , in addition, preferred to be small in order to reduce the size of the portable electronic apparatuses. The Japanese patent laid-open publication No.2002-231921, then, discloses a solid state imaging device using a wafer level chip size package (hereinafter referred to as WLCSP) which is packaged on a wafer. The applicant has filed US Serial No.10/839,231 for a camera module which employs the WLCSP type solid state imaging device on the date of May 6, 2004.

The WLCSP type solid state imaging device is as small as the bare chip, and is composed of a semiconductor substrate with a microlens array and a cover glass attached to the semiconductor substrate for protection of imaging elements in the solid state imaging device. With the outer dimension of a few millimeters square, such a small WLCSP type imaging device makes it very difficult to attach the filters on the cover glass.

In addition, as many as two thousand solid state imaging devices can be manufactured out of a single eight-inch semiconductor substrate, but forming optical filter layers on each of such numerous solid state imaging devices results in increase both of the manufacturing cost and the process steps.

### SUMMARY OF THE INVENTION

In view of the foregoing, a primary object of the present invention is to offer an optical filter layer formed on the cover glass of the WLCSP type solid state imaging device at low cost.

To achieve the above objects and other objects of the present invention, a large filter layer is formed on a transparent substrate before cutting a substrate assembly into individual imaging devices. In the substrate assembly, the transparent substrate is attached to a substrate wafer, on which a plurality of imaging sections are formed, with keeping a predetermined gap created by a spacer surrounding each of the image sections.

The optical filter layer is composed of optical filter plates or sheets attached on the transparent substrate, or of optical filter films deposited on the transparent substrate, and includes an infrared cut filter, an optical low pass filter, an anti-reflection filter and some such.

A manufacturing method for the solid state imaging device of the present invention includes a forming step of the optical filter layer on the surface of the transparent substrate, an attaching process of the transparent substrate to the semiconductor wafer having a plurality of imaging sections, and a cutting process of the transparent substrate and the semiconductor wafer along each of the imaging sections. In another embodiment of the present invention, the optical filter layer is formed on the surface of the transparent substrate after the transparent substrate is attached to the semiconductor wafer with a plurality of imaging sections.

The forming step of the optical filter layer is made by attaching optical filter plates or sheets to the transparent substrate.

A camera module of the present invention is provided with a circuit board, an optical unit, and the imaging device. The imaging device is placed inside the optical unit, and the optical unit is attached to the circuit board together with the imaging device. In the imaging device, an imaging section on a semiconductor substrate is packaged by a transparent substrate with keeping a predetermined gap created by a spacer. The semiconductor substrate and the transparent cover are formed by dicing both the semiconductor wafer having a plurality of imaging sections thereon and the transparent substrate having an optical filter layer.

According to the present invention, the optical filter layer can be formed on the cover glass of the WLCSP type solid state imaging device which has the outside dimension of as small as a few millimeters square. This configuration enables to downsize the camera module and, eventually, contributes to downsize the portable electronic apparatuses which incorporate the aforesaid camera module.

The optical filter layer on the cover glass surface can be the infrared cut filter, the optical low pass filter, the anti-reflection filter and some such, and besides, it can be made either by attaching or depositing. It is therefore possible to select an appropriate combination of kind and process in forming the optical filter layer according to performance and purpose of the solid state imaging device and the camera module.

Further, operations to be introduced is merely adding the optical filter layer on the surface of transparent substrate, it is therefore possible to minimize the cost rise.

### BRIEF DESCRIPTION OF THE DRAWINGS

The foregoing and other features and advantages of the present invention will become apparent from the following detailed descriptions of the preferred embodiments in conjunction with the accompanying drawings, which are given by way of illustration only and thus do not limit the present invention. In the drawings, the same reference numerals designate like or corresponding parts throughout the several views, and wherein:
Fig.1 is a cross sectional view illustrating constitution of a camera module of the present invention;
Fig.2 is an exterior perspective view of a solid state imaging device;
Fig.3 is a cross sectional view of the solid state imaging device;
Fig.4 is a flow chart illustrating a manufacturing process of the solid state imaging device;
Figs.5A to 5D are cross sectional views illustrating manufacturing process of the solid state imaging device;
Fig.6 is a perspective view of a semiconductor wafer and a glass substrate with an optical filter layer;
Fig.7 is a cross sectional view of the solid state imaging device provided with an infrared cut filter layer and an optical low pass filter layer;
Fig.8 is a cross sectional view illustrating a state where the infrared cut filter layer and the optical low pass filter layer are formed on the glass substrate by film deposition process;
Fig.9 is a cross sectional view of the solid state imaging device in which an anti-reflection layer is formed by film deposition;
Figs.10A to 10D are cross sectional views of the solid state imaging device illustrating procedure for forming the anti-reflection layer on the glass substrate;
Fig.11 is a cross sectional view of the solid state imaging device provided with the anti-reflection layer, the infrared cut filter layer, and the optical low pass filter layer; and
Fig.12 is a cross sectional view of a conventional camera module.

### DESCRIPTION OF THE PREFFERED EMBODIMENTS

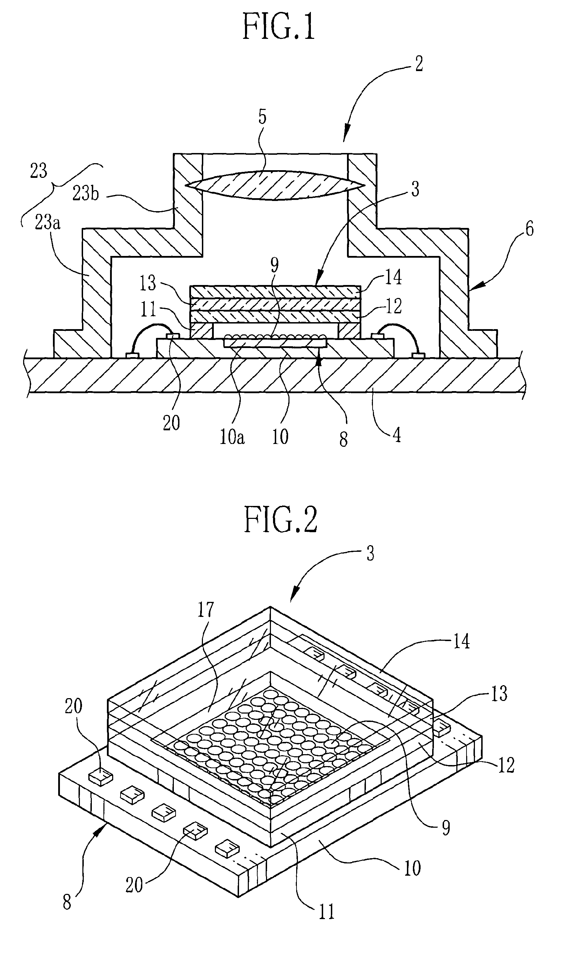

Referring now to Fig.1, a camera module 2 comprises a solid state imaging device 3, a mounting board 4 to the solid state imaging device 3, and an optical unit 6 attached to the mounting board 4. The optical unit 6 has a taking lens 5 placed above the solid state imaging device 3.

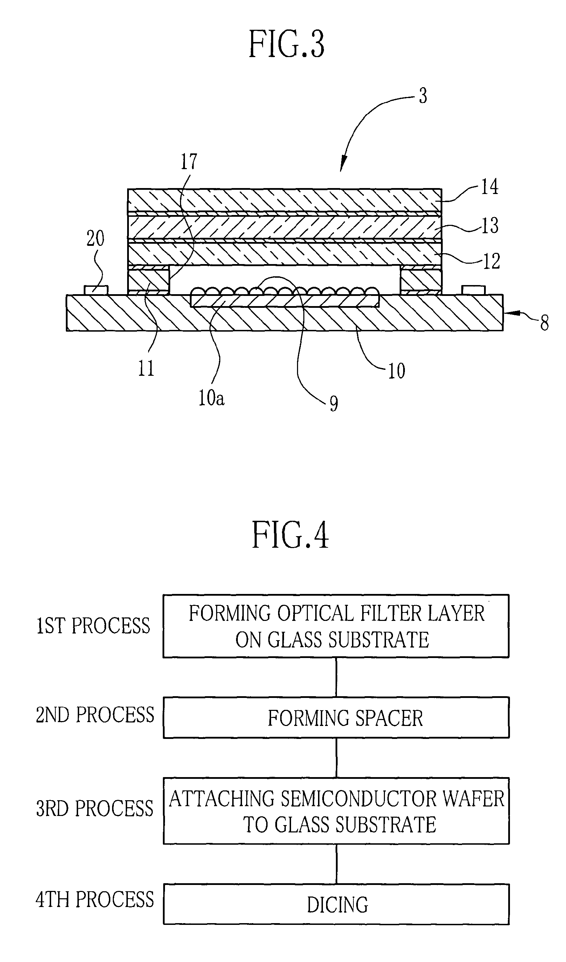

As shown in Fig.2 and Fig.3, the solid state imaging device 3 is composed of an imaging chip 8, a spacer 11, a cover glass 12, and an optical filter layer formed on the cover glass 12. The optical filter layer includes at least an infrared cut filter layer 13 and an optical low pass filter layer 14.

The imaging chip 8 is constituted of a semiconductor substrate 10 and a microlens array 9. The semiconductor substrate 10 is a chip diced off a silicon wafer, and an imaging section 10a is formed thereon. The imaging section 10a, as is commonly known, includes plural pixels arranged in a matrix, each of which pixels has a photoelectric conversion function and an electric charge accumulation function. The embodiment uses a CCD type imaging section which is composed of photodiodes and charge-coupled devices (CCD), however, a MOS type imaging section composed of photodiodes and MOS switches can also be used.

A mosaic filter is attached on the imaging section 10a so that one of a red section, a green section, or a blue section of the mosaic filter is located immediately above its corresponding pixel. In addition, the microlens array 9 is attached on the mosaic filter such that individual microlens agrees in position with each of the pixels.

The spacer 11 has a square shape with an opening 17 in the middle, and is attached to an upper surface of the semiconductor substrate 10 so as to enclose the imaging section 10a. The spacer 11 is made from inorganic material such as a silicon or the like. Creating a gap between the microlens array 9 and the cover glass (i.e. transparent cover) 12, the spacer 11 prevents the physical contact of microlens array 9 with the cover glass 12.

The cover glass 12 is attached to the upper surface of the spacer 11 to cover the opening 17. The cover glass 12 is also made of a low alpha-ray emission glass, protecting each pixel of the imaging section 10a from being destroyed by an alpha-ray.

Outside the spacer 11 on the semiconductor substrate 10, a plurality of outer connection terminals 20 are provided. The outer connection terminals 20 are linked to the imaging section 10a through wiring on the surface of the semiconductor substrate 10. The outer connection terminals 20 are connected by wire bonding to the mounting board 4.

The infrared cut filter layer 13 and the optical low pass filter layer 14 improve quality of the images captured with the solid state imaging device 3. The infrared cut filter layer 13 blocks the infrared ray within a particular wavelength range, eliminating ghost images and fog by the infrared light. The optical low pass filter layer 14 blocks high frequency components in the spatial frequency, eliminating false color and moire effects. Because the infrared cut filter layer 13 and the optical low pass filter layer 14 are bonded on the cover glass 12, the optical unit 6 need not have the attachment space dedicated for them, and the camera module 2 can thereby be downsized. Further, an anti-reflection filter layer may also be provided on the lower or upper surface of the cover glass 12 to prevent the incident light reflecting diffusely inside the solid state imaging device 3.

The mounting board 4 is a rigid board, made of a glass epoxy board or a ceramic board, and is attached to both the solid state imaging device 3 and the optical unit 6. The mounting board 4 is provided with a drive circuit for the solid state imaging device 3. The optical unit 6 comprises the taking lens 5 and a lens holder 23. The lens holder 23 includes a boxy base portion 23a to be attached to the mounting board 4 to cover the solid state imaging device 3 and a cylindrical lens barrel 23b to hold the taking lens 5.

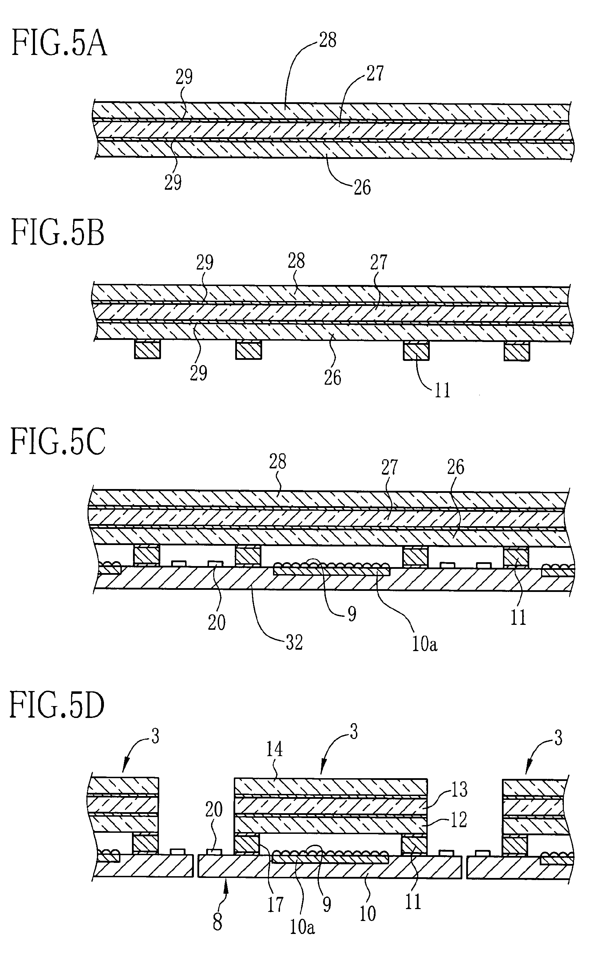

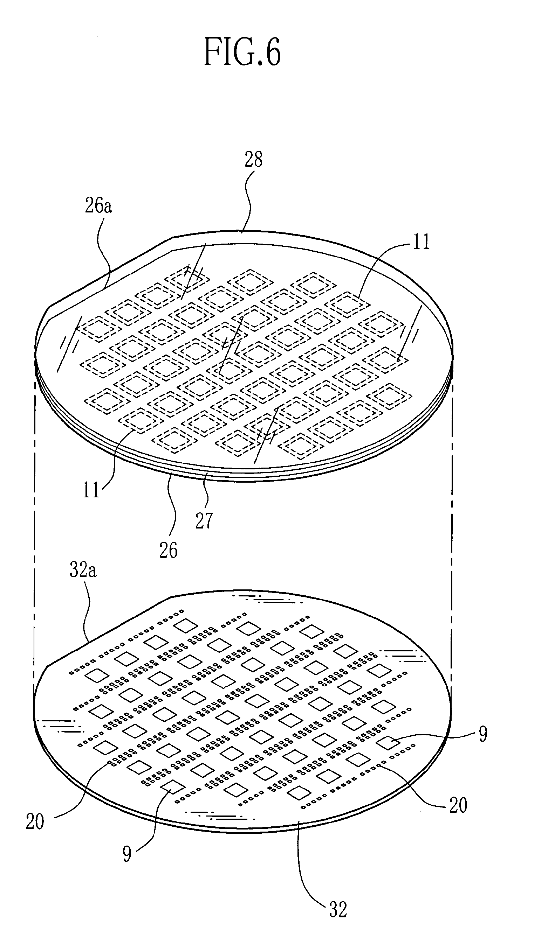

A manufacturing process for the solid state imaging device 3 is hereinafter described with reference to the flow chart of Fig. 4. In the first process, the optical filter layer is formed on a glass substrate 26, which is the base material of the cover glass 12. As shown in Fig.5A and Fig. 6, the optical filter layer is formed by bonding an infrared cut filter substrate 27 and an optical low pass filter substrate 28 to the glass substrate 26 with an adhesive agent 29. The infrared cut filter substrate 27 and the optical low pass filter substrate 28 are about the same size as the glass substrate 26.

The adhesive agent 29 may be a ultraviolet adhesive, which turns into transparency after hardening. The adhesive agent 29 is spread, with uniform thickness, on the entire surface of the glass substrate 26. In order to prevent air from incoming between the substrates, the glass substrate 26 is attached to the infrared cut filter substrate 27 under, for example, the vacuum environment. After attachment, one of the glass substrate 26 and the infrared cut filter substrate 27 is sucked with vacuum while the other is pressed with air pressure so that they stick to each other firmly. Subsequent ultraviolet irradiation through the glass substrate 26 hardens the adhesive agent 29, hence the glass substrate 26 and the infrared cut filter substrate 27 are put together tightly. The same attachment procedure as above applies to the optical low pass filter substrate 28 onto the infrared cut filter substrate 27, and its detailed explanation is omitted.

As shown in Fig.5B illustrating the second process, a plurality of the spacers 11 are formed on the lower surface of the glass substrate 26. The spacer 11 is formed under the following procedure. Firstly, a silicon wafer for the spacer is attached on the lower surface of the glass substrate 26 with an adhesive agent. Secondly, a resist mask in the shape of the spacer 11 is formed on the silicon wafer by photolithography. Lastly, the portions without the resist mask are removed by plasma etching to form pluralities of the spacers 11 on the glass substrate 26. After the etching, the remaining resist mask on the silicon wafer is removed by ashing or the like.

Fig.5C and Fig. 6 show the third process, in which the glass substrate 26 and a semiconductor wafer 32 are attached together with an adhesive agent. Formed in the semiconductor wafer 32 are a plurality of the imaging sections 10a, on each of which the microlens arrays 9 are attached. In this process, an alignment and bonding apparatus will be used. The alignment and bonding apparatus performs face to face alignment of the glass substrate 26 and the semiconductor wafer 32, with reference to their respective orientation flats 26a and 32a, in the XY and the rotation directions. Stacked and compressed by the alignment and bonding apparatus thereafter, the glass substrate 26 and the semiconductor wafer 32 are attached together with the adhesive agent to form a substrate assembly. Upon this attachment, each of the microlens arrays 9 is sealed by the spacer 11 and the glass substrate 26 on the semiconductor wafer 32, protected from dust in the subsequent processes.

Fig.5D shows the fourth process, in which the glass substrate 26, the infrared cut filter substrate 27 and the optical low pass filter substrate 28 both attached to the glass substrate 26, and the semiconductor wafer 32 are diced all together. In this process, the substrate assembly is placed on a dicing machine with a dicing tape adhering to the glass substrate 26. Pouring cooling water onto the substrate assembly, the dicing machine cuts off the glass substrate 26, the infrared cut filter substrate 27, the optical low pass filter substrate 28, and the semiconductor wafer 32 along each solid state imaging device 3 with using, for example, a metal resin grinding wheel which is made from diamond abrasive grains bonded with a resin. Besides, it is also possible to dice the glass substrate 26 firstly, and then dice the substrate wafer 32.

When an eight-inch wafer is used, as many as two thousand solid state imaging devices 3 are obtained all at once. Individually attaching the infrared cut filter layer 13 and the optical low pass filter layer 14 to each of these two thousand solid state imaging devices 3 may require considerable manufacturing costs and process steps. In this embodiment, however, the infrared cut filter substrate 27 and the optical low pass filter substrate 28 are attached to the glass substrate 26 before the glass substrate 26 and the semiconductor wafer 32 are diced together. This method only necessitates a single attaching process of the optical filter, and the manufacturing cost and the process steps are therefore reduced significantly.

The completed solid state imaging device 3 undergoes functional tests, and is attached to the mounting board 4 together with the optical unit 6 to compose the camera module 2. The camera module 2 is incorporated in the portable electronic apparatuses such as cellular phones or the like. With the infrared cut filter layer 13 and the optical low pass filter layer 14 formed on the cover glass 12 of the solid state and the optical low pass filter imaging device 3, the camera module 2 of this embodiment is able to downsize the optical unit 6 and, in fact, contributes to further downsizing of the portable electronic apparatuses which incorporate the camera module 2.

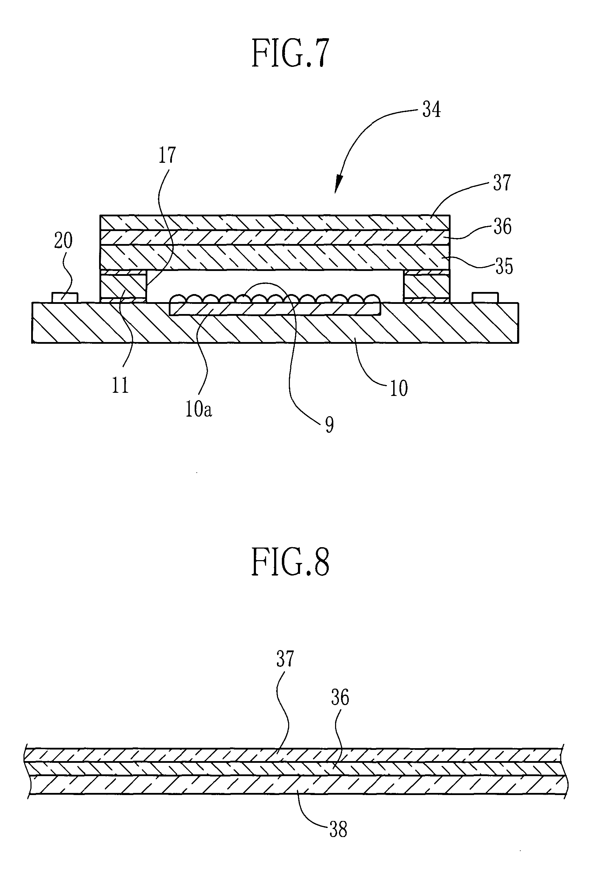

Although the optical filter layer is formed by attaching the sheet-like or plate-like infrared cut filter substrate 27 and optical low pass filter substrate 28 to the glass substrate 26 in the above embodiment, it is also possible to deposit films of an infrared cut filter layer 35 and an optical low pass filter layer 36 on a cover glass 35, as a solid state imaging device 34 shown in Fig.7.

In Fig.8, the optical filter layers are formed on a glass substrate 38, which is the base material of the cover glass 35, by means of a CVD (chemical vapor deposition) machine, a vacuum vapor deposition machine or the like. As with the first embodiment described above, the processes of forming the spacers, attaching the glass substrate 35 to the semiconductor wafer, and dicing will follow to manufacture pluralities of the solid state imaging devices 34 all at once.

Even in this embodiment, only a single deposition process is required for forming the optical filter layers on pluralities of the solid state imaging devices 34, and thus the manufacturing cost and the process steps are much reduced than in the case where every solid state imaging devices undergo the deposition process.

In any of the foregoing embodiments, the optical filter layer is formed on the glass substrate before the glass substrate is attached to the semiconductor wafer. The glass substrate may, however, be attached to the semiconductor wafer before the optical filter layer is formed on the glass substrate by attaching or depositing films.

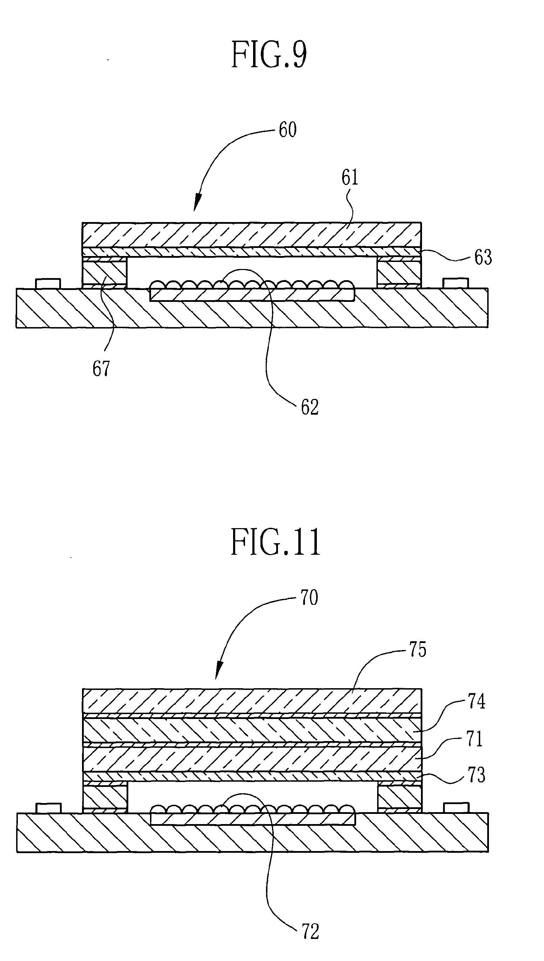

In addition, a solid state imaging device 60 shown in Fig.9 is provided with an anti-reflection filter layer 63 on the confronting surface of the cover glass 61 with a microlens array 62 in order to prevent the incident light reflecting diffusely inside the solid state imaging device 60.

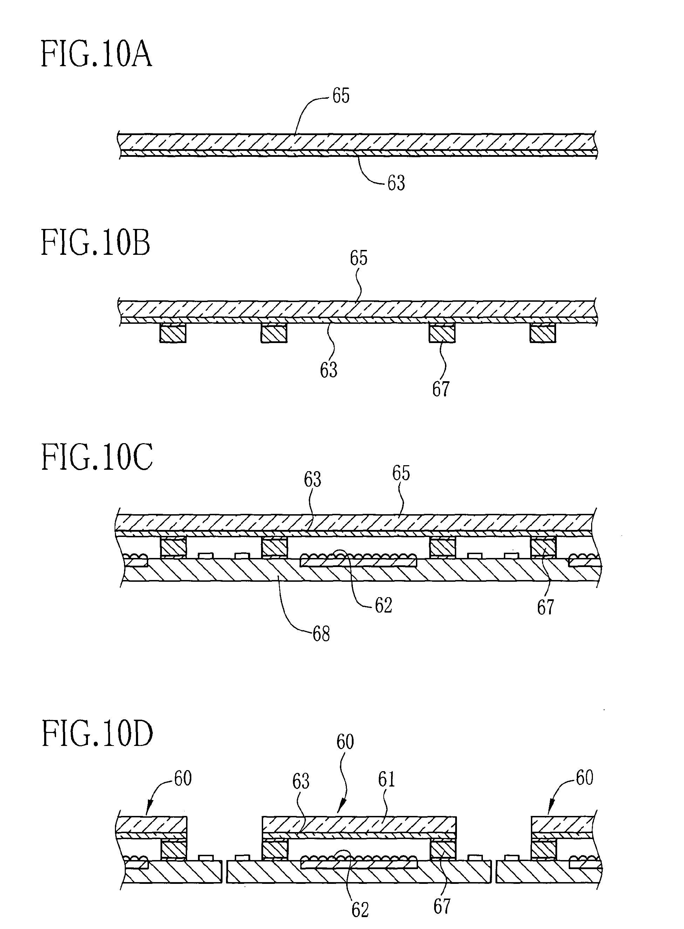

To manufacture the solid state imaging device 60, as shown in Fig.10A, the anti-reflection filter layer 63 is formed on a surface of a glass substrate 65, which is the base material of the cover glass 61, by such a film deposition method as the CVD or the vacuum vapor deposition. And a plurality of spacers 67 are formed on the anti-reflection filter layer 63 as shown in Fig.10B. Then, as shown in Fig.10C, the glass substrate 65 is attached to a semiconductor wafer 68. Meanwhile, the semiconductor wafer 68 has the same configuration as the semiconductor wafer 32 shown in Fig.5C, and its detailed explanation will be omitted. Finally, as shown in Fig.10D, the glass substrate 65 and the semiconductor wafer 68 are diced along each of the microlens arrays 62. This method provides the solid state imaging device 60 with the anti-reflection filter layer 63 on the lower surface, namely a facing surface to the microlens array 62, of the cover glass 61. The anti-reflection filter layer can also be formed by attaching an anti-reflection filter plate or sheet to the glass substrate.

In a solid state imaging device 70 shown in Fig.11, an anti-reflection filter layer 73 is formed on the lower surface of a cover glass 71 by the film deposition process. On the upper surface of the cover glass 71, an infrared cut filter layer 74 and an optical low pass filter layer 75 are formed either by attaching or depositing. When a plurality of optical filter layers are formed in a solid state imaging device, in addition, some filter layers may be formed by attaching and the others may be formed by depositing.

As described so far, the present invention is not to be limited to the above embodiments, and all matter contained herein is illustrative and does not limit the scope of the present invention. Thus, obvious modifications may be made within the spirit and scope of the appended claims.

## Claims

1. A solid state imaging device (3, 34, 60, 70), formed by attaching a transparent substrate (26) onto a semiconductor wafer (32) having a plurality of imaging sections while keeping a predetermined gap created with a spacer (11, 67) surrounding each of said imaging sections and then cutting said transparent substrate (26) and said semiconductor wafer (32) along each of said imaging sections, comprising:
an optical filter layer (13, 14, 36, 37, 63, 73, 74, 75) formed on a surface of said transparent substrate (26), being cut together with said transparent substrate (26).

2. A solid state imaging device as claimed in claim 1, wherein said optical filter layer (13, 14, 36, 37, 63, 73, 74, 75) is an optical filter plate or sheet attached on said transparent substrate (26).

3. A solid state imaging device as claimed in claim 2, wherein said optical filter layer (13, 14, 36, 37, 63, 73, 74, 75) is formed on an upper surface of said transparent substrate (26).

4. A solid state imaging device as claimed in claim 2, wherein said optical filter layer is an infrared cut filter (13, 36, 74) .

5. A solid state imaging device as claimed in claim 2, wherein said optical filter layer is an optical low pass filter (14, 37, 75).

6. A solid state imaging device as claimed in claim 2, wherein said optical filter layer is a stacked layer of an optical low pass filter (14, 37, 75) and an infrared cut filter (13, 36, 74).

7. A solid state imaging device as claimed in claim 1, wherein said optical filter layer (13, 14, 36, 37, 63, 73, 74, 75) is an optical filter film deposited on said surface of said transparent substrate (26).

8. A solid state imaging device as claimed in claim 7, wherein said optical filter layer (13, 14, 36, 37, 63, 73, 74, 75) is formed on an upper surface of said transparent substrate (26).

9. A solid state imaging device as claimed in claim 7, wherein said optical filter layer (13, 14, 36, 37, 63, 73, 74, 75) is formed on a lower surface of said transparent substrate.

10. A solid state imaging device as claimed in claim 7, wherein said optical filter layer is an infrared cut filter (13, 36, 74).

11. A solid state imaging device as claimed in claim 7, wherein said optical filter layer is an optical low pass filter (14, 37, 75).

12. A solid state imaging device as claimed in claim 7, wherein said optical filter layer is a stacked layer of an optical low pass filter (14, 37, 75) and an infrared cut filter (13, 36, 74).

13. A solid state imaging device as claimed in claim 7, wherein said optical filter layer is an anti-reflection filter (63, 73).

14. A solid state imaging device as claimed in claim 7, wherein said optical filter layer is a stacked layer of an optical low pass filter (14, 37, 75), an infrared cut filter (13, 36, 74), and an anti-reflection filter (63, 73).

15. A manufacturing method for a solid state imaging device (3, 34, 60, 70) comprising the steps of:
(A) forming an optical filter layer (13, 14, 36, 37, 63, 73, 74, 75) on a surface of a transparent substrate (26);
(B) attaching said transparent substrate (26) to a semiconductor wafer (32) having a plurality of imaging sections while keeping a predetermined gap; and
(C) cutting said transparent substrate (26) and said semiconductor wafer (32) along each of said imaging sections.

16. A manufacturing method as claimed in claim 15, wherein said step (A) is to attach an optical filter plate or sheet on said transparent substrate (26).

17. A manufacturing method as claimed in claim 15, wherein said step (A) is to deposit an optical filter film on said surface of said transparent substrate (26).

18. A manufacturing method as claimed in claim 16, wherein said step (A) is to form said optical filter layer on an upper surface of said transparent substrate (26).

19. A manufacturing method as claimed in claim 17, wherein said step (A) is to form said optical filter layer on an upper surface of said transparent substrate (26).

20. A manufacturing method as claimed in claim 17, wherein said step (A) is to form said optical filter layer on a lower surface of said transparent substrate (26).

21. A manufacturing method for a solid state imaging device (3, 34, 60, 70) comprising the steps of:
(A) attaching a transparent substrate (26) to a semiconductor wafer (32) having a plurality of imaging sections while keeping a predetermined gap;
(B) forming an optical filter layer (13, 14, 36, 37, 63, 73, 74, 75) on a surface of said transparent substrate (26); and
(C) cutting said transparent substrate (26) and said semiconductor wafer (32) along each of said imaging sections.

22. A manufacturing method as claimed in claim 21, wherein said step (B) is to attach an optical filter plate or sheet on an upper surface of said transparent substrate (26).

23. A manufacturing method as claimed in claim 21, wherein said step (B) is to deposit an optical filter film on an upper surface of said transparent substrate (26).

24. A camera module (2) comprising:
a circuit board (4);
an optical unit (6) attached on said circuit board (4), holding a taking lens (5);
an imaging device (3, 34, 60, 70) attached to said circuit board (4) inside said optical unit (6), said imaging device (3, 34, 60, 70) being formed by attaching a transparent substrate (26) onto a semiconductor wafer (32) having a plurality of imaging sections while keeping a predetermined gap and then dicing said semiconductor wafer (32) and said transparent substrate (26) along each of said imaging sections, said imaging device (3, 34, 60, 70) comprising:
(a) a semiconductor substrate (10) diced off from said semiconductor wafer (32), having said image section;
(b) a transparent cover (12, 35, 61, 71) diced off from said transparent substrate (26), for packaging said imaging section;
(c) an optical filter layer (13, 14, 36, 37, 63, 73, 74, 75) formed on said transparent cover (12, 35, 61, 71), said optical filter layer (13, 14, 36, 37, 63, 73, 74, 75) being formed on said transparent substrate (26) and diced together with said transparent substrate (26).
